# EUROPEAN PATENT APPLICATION

(11) **EP 4 810 647 A1**
(43) Date of publication of application: **23.09.2026**
(21) Application number: 26160806.1
(22) Date of filing: 25.02.2026
(51) Int. Cl.: C23C 14/02, C23C 4/02, C23C 4/11, C23C 4/12, H01J 37/34, C23C 24/04

(54) **STRUCTURAL MEMBER**

(30) Priority: 19.03.2025 JP 2025044686
(71) Applicant: TOTO LTD., Kokurakita-ku Kitakyushu-shi, Fukuoka 802-8601 (JP)
(72) Inventor: Kamada, Shohei, Kitakyushu-shi, 802-8601 (JP); Koga, Tatsuya, Kitakyushu-shi, 802-8601 (JP)
(74) Representative: Bandpay & Greuter

(57) **Abstract**

A structural member 10 includes a base material 100 formed of a polycrystalline material, and a protective film 200 covering a surface 110 of the base material 100. In a cross section obtained by cutting the base material 100 perpendicular to the surface 110, when an average value of cross-sectional areas of multiple crystal grains 150F exposed on the surface 110 among crystal grains 150 constituting the base material 100 is defined as a first cross-sectional area, and an average value of cross-sectional areas of multiple crystal grains 150B located deeper than the surface 110 among the crystal grains 150 constituting the base material 100 is defined as a second cross-sectional area, the first cross-sectional area is smaller than the second cross-sectional area in the structural member 10.

## Description

### CROSS-REFERENCE TO RELATED APPLICATION

This application is based upon and claims the benefit of priority from Japanese Patent Application No. 2025-044686 filed on March 19, 2025, the entire contents of which are incorporated herein by reference.

### Field

The present invention relates to a structural member.

### Background

Members constituting a semiconductor manufacturing apparatus, such as members serving as an inner wall of a chamber, are required to have durability against plasma. Accordingly, as such a member, a structural member having a protective film formed on a base material, as disclosed, for example, in Japanese Patent Laid-Open No. 2007-321183, is commonly used. A polycrystalline material such as alumina is often used as the base material. A material such as yttria is often used as the protective film.

### Summary

In the above structural member, it is necessary to enhance the adhesion between the protective film and the base material to prevent the protective film exposed to plasma from deteriorating and scattering as particles. In conventional structural members, there has been room for improvement in how the surface properties of the base material should be adjusted in advance to form a protective film having high adhesion.

The present invention has been made in view of such a problem, and an object of the present invention is to provide a structural member capable of enhancing the adhesion of a protective film to the surface of a base material.

To solve the above problem, the structural member of the present invention comprises a base material formed of a polycrystalline material and a protective film covering the surface of the base material. In a cross section obtained by cutting the base material perpendicular to the surface, when an average value of cross-sectional areas of multiple crystal grains exposed on the surface among crystal grains constituting the base material is defined as a first cross-sectional area, and an average value of cross-sectional areas of multiple crystal grains located deeper than the surface among the crystal grains constituting the base material is defined as a second cross-sectional area, the first cross-sectional area is smaller than the second cross-sectional area in the structural member.

If the surface properties of the base material are adjusted before film formation so that the first cross-sectional area becomes smaller than the second cross-sectional area, the proportion of the cross sections of the crystal grains, namely the surfaces that were within grains, rather than grain boundaries, becomes relatively large on that surface. The cross sections of crystal grains readily plastically deform and are also more chemically active than grain boundaries. Therefore, by using, for example, the aerosol deposition method or physical vapor deposition, a film having high adhesion can be formed on the surface of the base material.

The present invention provides a structural member capable of enhancing the adhesion of a protective film to the surface of a base material.

### Brief Description of the Drawings

FIG. 1 is a schematic cross-sectional view of the structural member of the present embodiment;
FIG. 2 is a view for explaining the surface properties and the like of the base material of the structural member of the present embodiment;
FIG. 3 is a view for explaining the surface properties and the like of the base material of the structural member of the present embodiment;
FIG. 4 is a view for explaining the surface properties and the like of the base material of the structural member of the present embodiment; and
FIG. 5 is a view for explaining the surface properties and the like of the base material of the structural member of Comparative Example.

### Detailed Description

Hereinafter the present embodiment will be described with reference to attached drawings. For clarity of description, identical reference numerals are used to denote the same elements in all figures, and redundant descriptions are omitted.

The first embodiment will be described. The structural member 10 of the present embodiment is configured as a member for a semiconductor manufacturing apparatus such as a plasma etching apparatus. Specifically, the structural member 10 is used as an inner wall of a processing chamber of a semiconductor manufacturing apparatus. This application of the structural member 10 is merely an example. The structural member 10 may also be a member disposed inside the processing chamber of the semiconductor manufacturing apparatus, such as a focus ring.

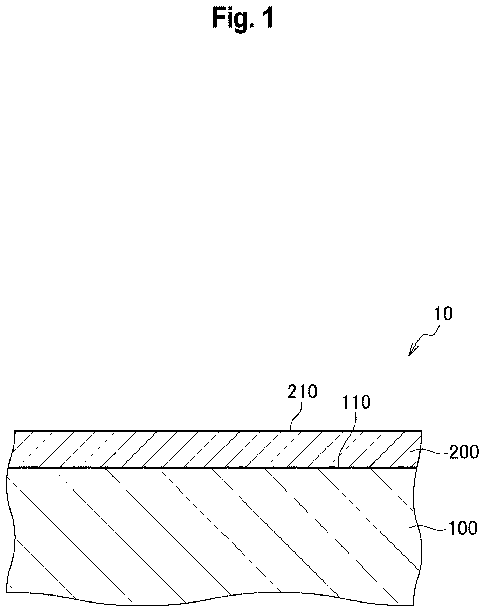

As shown in FIG. 1, the structural member 10 includes a base material 100 and a protective film 200. In a plasma etching apparatus or the like, the surface 210 of the protective film 200 is exposed to the interior of the process chamber. The protective film 200 is formed to protect the surface 110 of the base material 100 from plasma.

The base material 100 is a member forming the primary portion of the structural member 10. The base material 100 is formed of a polycrystalline material. In the present embodiment, the base material 100 is a sintered ceramic body containing high-purity alumina (Al₂O₃) as a main component, but it may be formed of another polycrystalline material. The surface 110 of the base material 100 is flat in the present embodiment, but may be curved. A portion of the surface 110 may be inclined.

The protective film 200 is formed to protect the base material 100 from plasma as described above. The protective film 200 is formed to cover the entire surface 110 of the base material 100. The protective film 200, for example, is formed of a material containing yttria (Y₂O₃) as a main component, but may be formed of another material. The protective film 200 of the present embodiment is formed using the aerosol deposition method, but may be formed by other film-forming methods such as physical vapor deposition (PVD).

In the present description, "main component" refers to the compound present in the greatest amount in the subject (e.g., base material 100). Specifically, "main component" refers to a compound that, when quantitative or semi-quantitative analysis is performed using X-ray diffraction (XRD), is confirmed to be present in a relatively greater volume ratio or mass ratio than any other compound contained in the subject. For example, in the present embodiment, the proportion of the main component (alumina) in the base material 100 is greater than 50% in volume or mass ratio. The proportion may be greater than 70%, may be greater than 90%, and may be 100%.

The thickness of the protective film 200 is appropriately adjusted depending on the duration for which durability is required to be maintained and other factors. In the present embodiment, the protective film 200 has a thickness of 15 µm or less.

In the structural member 10 used in semiconductor manufacturing apparatuses and the like, it is necessary to enhance the adhesion between the protective film 200 and the base material 100 to prevent the protective film 200 exposed to plasma from deteriorating and scattering as particles. To achieve this, it is considered important to appropriately adjust the properties of the surface 110 of the base material 100 before forming the protective film 200. The "properties of the surface 110" refer to parameters such as roughness of the surface 110.

However, the present inventors have found through experiments that simply adjusting the properties of the surface 110 so that indicators such as the arithmetic mean roughness (Ra) of the surface 110 become a predetermined value or less does not necessarily ensure that the adhesion of the protective film 200 is enhanced sufficiently and in a stable manner.

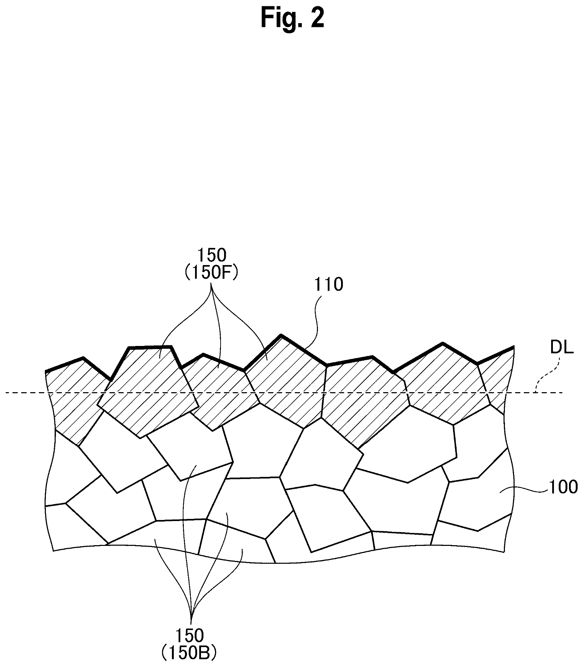

Accordingly, the inventors have focused on the distribution of the shapes of the crystal grains 150 constituting the base material 100 (not shown in FIG. 1; see FIG. 2 and other figures) in a cross section obtained by cutting the base material 100 perpendicular to the surface 110, i.e., the cross section shown in FIG. 1. As a result, the present inventors have found a new indicator described below.

The cross section shown in FIG. 2 is a part of the cross section obtained when the base material 100 is cut perpendicular to the surface 110. The same figure also illustrates cross sections of multiple crystal grains 150 constituting the base material 100. The lines drawn between adjacent crystal grains 150 represent the interfaces between the crystal grains. In the cross section of FIG. 2, the surface 110 is indicated by a thick line.

For convenience of explanation, among multiple crystal grains 150, those crystal grains 150 whose portions are exposed on the surface 110 are hereinafter also referred to as "crystal grains 150F." All the other crystal grains 150, that is, all the crystal grains 150 located deeper than the surface 110, are hereinafter also referred to as "crystal grains 150B." In FIG. 2, only the cross sections of the crystal grains 150F are provided with hatching.

At the point shown in FIG. 2, no protective film 200 has yet been formed on the base material 100. In addition, no processing such as polishing for adjusting the properties of the surface 110 has been performed. The cross-sectional shapes of most of the crystal grains 150F exposed on the surface 110 remain as the original cross-sectional shapes immediately after sintering. Accordingly, on most portions of the surface 110, the interfaces of the crystal grains 150F are exposed. In addition, the average value of the cross-sectional areas of the crystal grains 150F and the average value of the cross-sectional areas of the crystal grains 150B are approximately equal to each other.

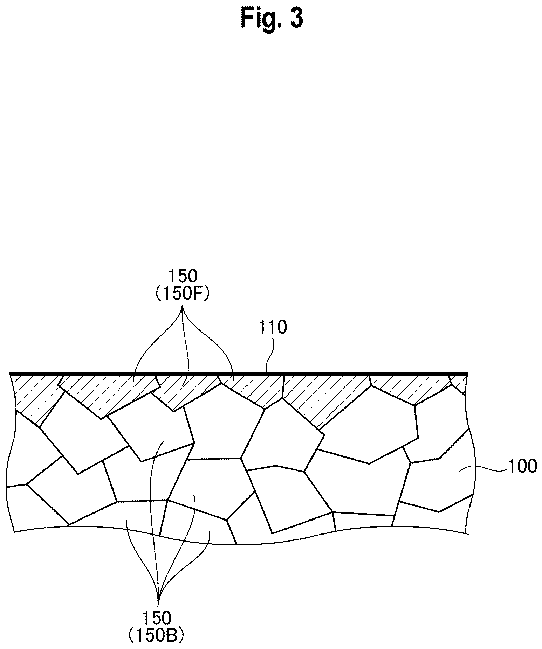

The state shown in FIG. 2 can be made into the state shown in FIG. 3 by removing a portion of the base material 100 on the side of the surface 110. In FIG. 2, the boundary between the portion that is removed by the above processing and the portion that is not removed is indicated by a dotted line DL. As an example of such processing, precise polishing using abrasive particles that are smaller than usual can be employed.

Among the multiple crystal grains 150, those that were crystal grains 150F (i.e., the hatched ones) in FIG. 2 remain crystal grains 150F at the stage shown in FIG. 3. However, each crystal grain 150F has a cross-sectional shape that has changed from the original shape because a portion of the grain has been removed. Accordingly, on most portions of the surface 110, a new surface that was within the crystal grains 150F, rather than the interfaces of the crystal grains 150F, is exposed. In addition, the average cross-sectional area of the crystal grains 150F is smaller than the average cross-sectional area of the crystal grains 150B.

In the example of FIG. 3, the new surface 110 is depicted as a straight line, but the shape of the surface 110 need not be straight. The crystal grains 150F at the stage shown in FIG. 3 may be those that were crystal grains 150F at the stage shown in FIG. 2, or they may be those that were crystal grains 150B at the stage shown in FIG. 2. In either case, it is sufficient that most portions of the surface 110 are occupied by new surfaces that were within the crystal grains 150.

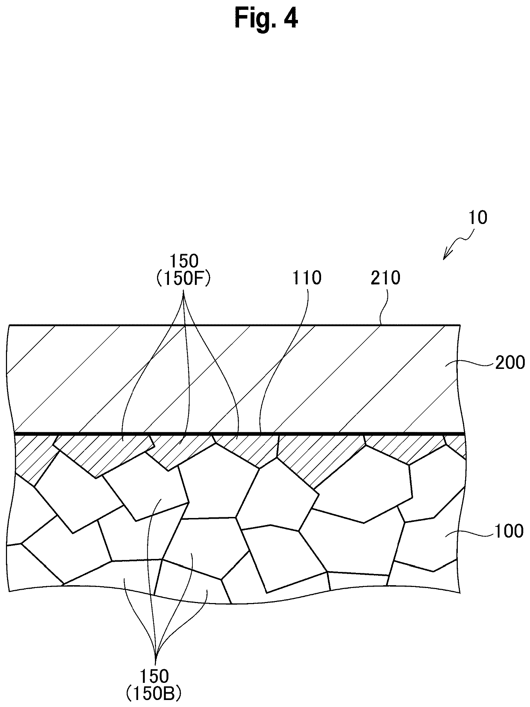

When a protective film 200 is formed on the base material 100 whose properties of the surface 110 have been adjusted as in FIG. 3, for example by using the aerosol deposition method, the state shown in FIG. 4 is obtained, and the structural member 10 having the configuration shown in FIG. 1 is completed.

As is well known, in the aerosol deposition method, fine particles serving as the material for the protective film 200 are dispersed in a gas to form an "aerosol," which is then sprayed from a nozzle toward the surface 110 to collide with it. On the surface 110, the fine particles are deformed or fragmented due to the impact of collisions, bonding to each other and gradually depositing as the protective film 200.

At the stage shown in FIG. 3, most portions of the surface 110 are occupied by new surfaces that were within the crystal grains 150. Such surfaces deform plastically more readily than the interfaces of the crystal grains 150, and also exhibit relatively high chemical activation energy. Accordingly, when the protective film 200 is formed on the surface 110 of FIG. 3 using the aerosol deposition method, the surface 110 plastically deforms relatively easily when impacted by fine particles, thereby facilitating firm fixation of the fine particles to the surface 110. As a result, the adhesion of the protective film 200 to the surface 110 is significantly enhanced compared with the conventional case.

The same applies when the protective film 200 is formed by a physical vapor deposition method. At the stage shown in FIG. 3, the chemical activation energy of the surface 110 is relatively high, so that atoms and the like serving as raw materials readily adhere to and deposit on the surface 110. Consequently, a protective film 200 having high adhesion can be formed on the surface 110.

If the protective film 200 were formed while the surface 110 remained in the state shown in FIG. 2, most of the protective film 200 would be deposited on the interfaces of the crystal grains 150F. In other words, most portions of the protective film 200 would be formed on the surface 110, which is less susceptible to plastic deformation and has relatively low chemical activation energy. Accordingly, the adhesion of the protective film 200 would be lower than that in the present embodiment shown in FIG. 4.

Even when a portion of the surface 110 of the base material 100 is removed prior to the formation of the protective film 200, the state of FIG. 3 is not always obtained. For example, even if the base material 100 shown in FIG. 2 is polished, depending on the polishing conditions, a new surface that was within the crystal grains 150 may be hardly exposed on the surface 110, and a different interface may become exposed due to detachment of the crystal grains 150F.

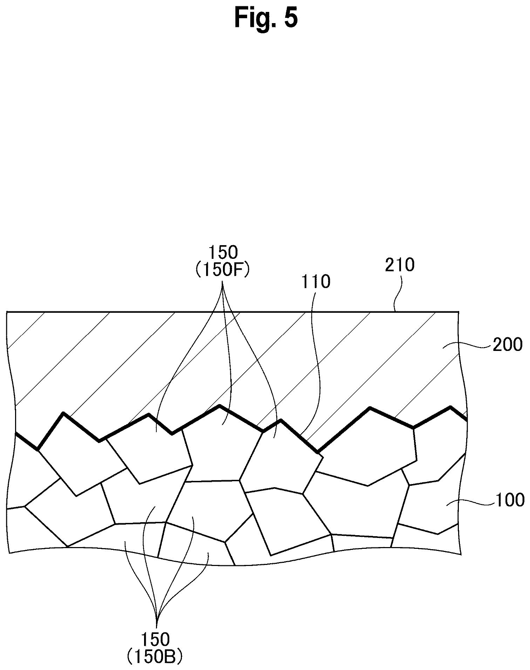

For example, in Comparative Example shown in FIG. 5, the crystal grains 150F that were hatched in FIG. 2 have been detached by polishing or the like, and a protective film 200 is formed so as to cover the surface 110 of newly exposed crystal grains 150F. In this example, most of the surface 110 is still occupied by interfaces of the crystal grains 150F. In other words, similar to the surface 110 of FIG. 2, the surface 110 of FIG. 5 is a surface that is less susceptible to plastic deformation and has relatively low chemical activation energy. Accordingly, the adhesion of the protective film 200 formed thereon is low.

As described above, simply removing a portion of the surface 110 of the base material 100 does not necessarily enhance the adhesion of the protective film 200. To enhance the adhesion of the protective film 200, it is essential to expose a large number of new surfaces that were within the interiors of the crystal grains 150 on the surface 110 of the base material 100.

The average value of the cross-sectional areas of multiple crystal grains 150F among the crystal grains 150 in the cross section shown in FIG. 2 and FIG. 3 is hereinafter also referred to as the "first cross-sectional area." Similarly, the average value of the cross-sectional areas of multiple crystal grains 150B among the crystal grains 150 in the cross section shown in FIG. 2 and FIG. 3 is hereinafter also referred to as the "second cross-sectional area". In the present embodiment, as a result of adjusting the properties of the surface 110 to achieve the state of FIG. 3, the first cross-sectional area is smaller than the second cross-sectional area.

If properties of the surface 110 are adjusted in advance so that the first cross-sectional area and the second cross-sectional area satisfy the above indicators, a large number of new surfaces that were within the interiors of the crystal grains 150 can be exposed on the surface 110. As a result, the adhesion of the protective film 200 to the surface 110 of the base material 100 can be sufficiently enhanced. More preferably, if properties of the surface 110 are adjusted in advance so that the first cross-sectional area is smaller than 70% of the second cross-sectional area, the adhesion of the protective film 200 can be sufficiently enhanced.

As a method for adjusting properties of the surface 110, various methods may be used in addition to the precise polishing described above.

Before the protective film 200 is formed, the surface 110 is preferably adjusted so that its arithmetic mean roughness (Ra) is 0.1 µm or less. By preliminarily smoothing the surface 110, the adhesion of the protective film 200 can be enhanced more reliably. However, as described above, merely setting the arithmetic mean roughness (Ra) of the surface 110 to 0.1 µm or less may not ensure the adhesion of the protective film 200. Even when the arithmetic mean roughness (Ra) of the surface 110 is 0.1 µm or less, there may be cases in which most of the surface 110 is occupied by interfaces of the crystal grains 150, as in the example shown in FIG. 5.

The arithmetic mean roughness of the surface 110 may be determined using various known methods. The arithmetic mean roughness of the surface 110 may also be determined even after the protective film 200 has been formed, for example, by the following method.

First, the structural member 10 is cut perpendicular to the surface 110, and a section similar to that shown in FIG. 4 is used as a measurement section. A predetermined region of the section is imaged using a laser microscope. As the laser microscope, for example, a VK-X3000 manufactured by KEYENCE may be used. For example, by using an objective lens with a magnification of 50×, an image with a magnification of 1,000× can be obtained.

Subsequently, the arithmetic mean roughness Ra of the surface 110 is calculated from profile data obtained from the image. The "reference length" indicating the measurement range may be set to, for example, 250 µm. The cutoff wavelength λs may be set to 0.8 µm, and the arithmetic mean roughness Ra may be calculated using a stylus mode. In this case, the stylus tip radius may be set to 2 µm, and the stylus tip angle may be set to 60°. Measurement may be performed at twenty distinct positions on the surface 110, and the arithmetic mean roughness Ra may then be calculated by averaging the obtained values.

The present embodiment has been described with reference to examples. However, the present disclosure is not limited to these examples. Modifications made to the foregoing examples by those skilled in the art fall within the scope of the present disclosure, provided that they retain the characteristics of the present disclosure. The elements of the foregoing examples, including their configurations, conditions, shapes, and the like, are not limited to those illustrated and can be modified as appropriate. The elements of the foregoing examples can be variously combined, provided that no technical contradiction arises.

## Claims

1. A structural member comprising:
a base material formed of a polycrystalline material, and
a protective film covering a surface of the base material, wherein
in a cross section obtained by cutting the base material perpendicular to the surface,
when an average value of cross-sectional areas of multiple crystal grains exposed on the surface among crystal grains constituting the base material is defined as a first cross-sectional area, and
an average value of cross-sectional areas of multiple crystal grains located deeper than the surface among the crystal grains constituting the base material is defined as a second cross-sectional area,
the first cross-sectional area is smaller than the second cross-sectional area.

2. The structural member according to claim 1, wherein the first cross-sectional area is smaller than 70% of the second cross-sectional area.

3. The structural member according to claim 1 or 2,
wherein the protective film is formed by using an aerosol deposition method.

4. The structural member according to claim 1 or 2,
wherein the protective film is formed by a physical vapor deposition method.

5. The structural member according to any one of claims 1 to 4, wherein the arithmetic mean roughness of the surface is 0.1 µm or less.
